# EUROPEAN PATENT SPECIFICATION

(11) **EP 3 293 576 B1**
(45) Date of publication and mention of the grant of the patent: **19.07.2023**
(21) Application number: 17185142.1
(22) Date of filing: 07.08.2017
(51) Int. Cl.: G03F 9/00, G03F 7/20

(54) **PATTERN EXPOSURE DEVICE, EXPOSURE HEAD, AND PATTERN EXPOSURE METHOD**
MUSTERBELICHTUNGSVORRICHTUNG, BELICHTUNGSKOPF UND MUSTERBELICHTUNGSVERFAHREN
DISPOSITIF D'EXPOSITION DE MOTIF, TÊTE D'EXPOSITION, ET PROCÉDÉ D'EXPOSITION DE MOTIF

(30) Priority: 09.09.2016 JP 2016176468
(43) Date of publication of application: 14.03.2018
(73) Proprietor: SCREEN Holdings Co., Ltd., Kyoto 602-8585 (JP)
(72) Inventor: Mizuno, Hirofumi, KYOTO-SHI, Kyoto 602-8585 (JP); Shigeno, Yukihide, KYOTO-SHI, Kyoto 602-8585 (JP); Uemura, Haruo, KYOTO-SHI, Kyoto 602-8585 (JP)
(74) Representative: Kilian Kilian & Partner

(56) References cited:
- US-A1- 2004 189 970
- US-A1- 2005 270 512
- US-A1- 2009 046 262
- US-A1- 2009 251 676

## Description

### BACKGROUND OF THE INVENTION

### Field of the Invention

The present invention relates to a technology of performing focusing of patterned light when pattern exposure is performed.

### Description of the Background Art

Japanese Patent Application Laid-Open No. 2004-335692 discloses a projection exposure device configured to expose a predetermined pattern on a photosensitive material by irradiating the photosensitive material with patterned light formed through spatial modulation.

In the above-described project exposure device, light output from a light source is subjected to spatial modulation through a micro mirror device (DMD) to form patterned light. The patterned light is imaged onto the photosensitive material through an optical system.

The above-described optical system includes, for example, a first imaging optical system configured to image the patterned light formed through the DMD, a micro lens array disposed on an imaging plane of the first imaging optical system, and a second imaging optical system configured to image light that has passed through the micro lens array onto the photosensitive material. The micro lens array includes a plurality of two-dimensionally arrayed micro lenses corresponding to respective micro mirrors of the DMD.

Japanese Patent Application Laid-Open No. 2004-335692 also discloses that an air-space adjusting unit using a prism is provided between the second imaging optical system and the photosensitive material. The air-space adjusting unit allows change in an air space between the second imaging optical system and the photosensitive material, and hence adjustment of the imaging position (focus position) of light (patterned light) output from the second imaging optical system.

The second imaging optical system and the photosensitive material are typically designed to have a gap as small as possible to achieve pattern exposure at high resolution. Thus, it is difficult in some cases to provide the air-space adjusting unit between the second imaging optical system and the photosensitive material as disclosed in Japanese Patent Application Laid-Open No. 2004-335692. Moreover, the air-space adjusting unit provided in such a small gap potentially makes it difficult to perform maintenance.

The prior art document US 2009 046 262 A1 discloses a pattern exposure device according to the preamble of claim 1.

A further prior art document is US 2005 270 512 A1.

### SUMMARY OF THE INVENTION

The present invention is directed to a pattern exposure device.

A pattern exposure device in a first aspect includes: a holding unit configured to hold a photosensitive material; an exposure head configured to output patterned light toward the photosensitive material; a measurement unit configured to measure the position of the photosensitive material held by the holding unit; and a focus control unit configured to adjust an imaging position of the patterned light in accordance with the position of the photosensitive material. The exposure head includes: a spatial light modulator including a plurality of modulation elements configured to form patterned light by performing spatial light modulation on light output from a light source; a first imaging optical system including a first lens and a second lens disposed on an optical path of patterned light output from the spatial light modulator, the second lens being telecentric on an image side; a micro lens array including a plurality of micro lenses configured to condense the patterned light that has passed through the second lens of the first imaging optical system; a second imaging optical system disposed on an optical path of the patterned light that has passed through the micro lens array and configured to image the patterned light; and a lens moving unit configured to integrally move the second lens and the micro lens array in directions toward and away from the first lens. The focus control unit adjusts the imaging position of the patterned light by controlling operation of the lens moving unit.

The focal position of patterned light output from the second imaging optical system can be adjusted by moving the second lens of the first imaging optical system and the micro lens array. In addition, no focusing component needs to be provided between the second imaging optical system and the photosensitive material, which allows the second imaging optical system to move close to the photosensitive material. For these reasons, pattern exposure can be excellently performed.

A second aspect is the pattern exposure device in the first aspect, in which the second imaging optical system is telecentric on image and object sides.

According to the pattern exposure device in the second aspect, the size of an image of the patterned light is constant when the position of the photosensitive material is shifted in the direction of the optical axis of the patterned light because the second imaging optical system has a constant lateral magnification. This configuration achieves accurate exposure. Since the second imaging optical system is telecentric on an object side, the size of an image of the patterned light on an image side of the second imaging optical system can be maintained when the second lens of the first connect optical system and the micro lens array are moved in the direction of the optical axis.

A third aspect is the pattern exposure device in the first or second aspect, in which the first imaging optical system is an enlarging optical system configured to achieve imaging at a lateral magnification exceeding one.

According to the pattern exposure device in the third aspect, the first imaging optical system is an enlarging optical system, and thus an image of patterned light can be formed in an enlarged manner on the photosensitive material.

A fourth aspect is the pattern exposure device according to the third aspect, further including an exposure-head supporting unit configured to support a plurality of the exposure heads arranged side by side.

According to the pattern exposure device in the fourth aspect, the size of the lens moving unit can be reduced, and accordingly the size of each exposure head can be reduced. Thus, interference between the exposure heads can be suppressed when the plurality of exposure heads is held being arranged side by side. In addition, the size reduction allows appropriate intervals to be provided, which facilitates maintenance involving, for example, coupling and decoupling and various adjustments.

A fifth aspect is the pattern exposure device according to any of one the first to fourth aspects, in which the second imaging optical system is an enlarging optical system configured to achieve imaging at a lateral magnification larger than a lateral magnification of the first imaging optical system.

According to the pattern exposure device in the fifth aspect, the second imaging optical system has a magnification larger than that of the first imaging optical system, which leads to improved throughput of exposure. When the second lens of the first imaging optical system and the micro lens are moved in focusing, the size of the lens moving unit can be reduced as compared to a case in which a lens of the second imaging optical system, which has a large diameter and a heavy weight, is moved. In addition, the amounts of moving of the second lens of the first imaging optical system and the micro lens can be reduced in accordance with the magnification of the second imaging optical system, which allows reduction in the size of a movement drive system. Accordingly, the size of each exposure head can be reduced.

An exposure head configured to output patterned light according to a sixth aspect includes: a spatial light modulator including a plurality of modulation elements configured to form patterned light by performing spatial light modulation on light output from a light source; a first imaging optical system including a first lens and a second lens disposed on an optical path of patterned light output from the spatial light modulator, the second lens being telecentric on an image side; a micro lens array including a plurality of micro lenses configured to condense the patterned light that has passed through the second lens of the first imaging optical system; a second imaging optical system disposed on an optical path of the patterned light that has passed through the micro lens array and configured to image the patterned light, the second imaging optical system being telecentric on image and object sides; and a lens moving unit configured to integrally move the second lens and the micro lens array in directions toward and away from the first lens.

According to the exposure head in the sixth aspect, the focal position of patterned light output from the second imaging optical system can be adjusted by moving the second lens of the first imaging optical system and the micro lens array. In addition, no focusing component needs to be disposed between the second imaging optical system and the photosensitive material, which allows the second imaging optical system to move close to the photosensitive material. For these reasons, pattern exposure can be excellently performed.

A pattern exposure method according to a seventh aspect includes: a process (a) of holding a photosensitive material; a process (b) of outputting patterned light toward the photosensitive material; a process (c) of measuring the position of the photosensitive material; and a process (d) of adjusting an imaging position of the patterned light in the process (b) in accordance with the position of the photosensitive material measured in the process (c). The process (b) includes: a process (b-1) of forming the patterned light by providing spatial modulation, through a plurality of modulation elements, on light output from a light source; a process (b-2) of imaging the patterned light through a first imaging optical system including a first lens and a second lens disposed on an optical path of the patterned light, the second lens being telecentric on an image side; a process (b-3) of condensing, through a micro lens array including a plurality of micro lenses, the patterned light output from the second lens of the first imaging optical system in the process (b-1); and a process (b-4) of imaging, through a second imaging optical system, the patterned light that has passed through the micro lens array in the process (b-3). The process (d) includes a process (d-1) of **integrally** moving the second lens and the micro lens array in directions toward and away from the first lens.

According to the exposure method in the seventh aspect, the focal position of patterned light output from the second imaging optical system can be adjusted by **integrally** moving the second lens of the first imaging optical system and the micro lens array. In addition, no focusing component needs to be disposed between the second imaging optical system and the photosensitive material, which allows the second imaging optical system to move close to the photosensitive material. For these reasons, pattern exposure can be excellently performed.

Thus, it is an object of the present invention to provide a technology of excellently performing focusing of patterned light.

These and other objects, features, aspects and advantages of the present invention will become more apparent from the following detailed description of the present invention when taken in conjunction with the accompanying drawings.

### BRIEF DESCRIPTION OF THE DRAWINGS

FIG. 1 is a side view illustrating a pattern exposure device 10 according to a preferred embodiment;
FIG. 2 is a plan view illustrating the pattern exposure device 10 according to the preferred embodiment;
FIG. 3 is a schematic perspective view illustrating the configuration of an exposure unit 800 according to the preferred embodiment;
FIG. 4 is a schematic side view illustrating the configuration of an exposure head 82 according to the preferred embodiment;
FIG. 5 is a block diagram illustrating bus wiring of the pattern exposure device 10 according to the preferred embodiment; and
FIG. 6 is a schematic perspective view illustrating a plurality of the exposure heads 82 performing pattern exposure.

### DESCRIPTION OF THE PREFERRED EMBODIMENTS

The following describes a preferred embodiment of the present invention with reference to the accompanying drawings. Components disclosed in the preferred embodiment are merely exemplary, and thus the scope of the present invention is not limited to the components. In the drawings, the dimensions of the components and the numbers thereof are exaggerated or simplified as necessary to facilitate understanding in some cases.

### <1. First preferred embodiment>

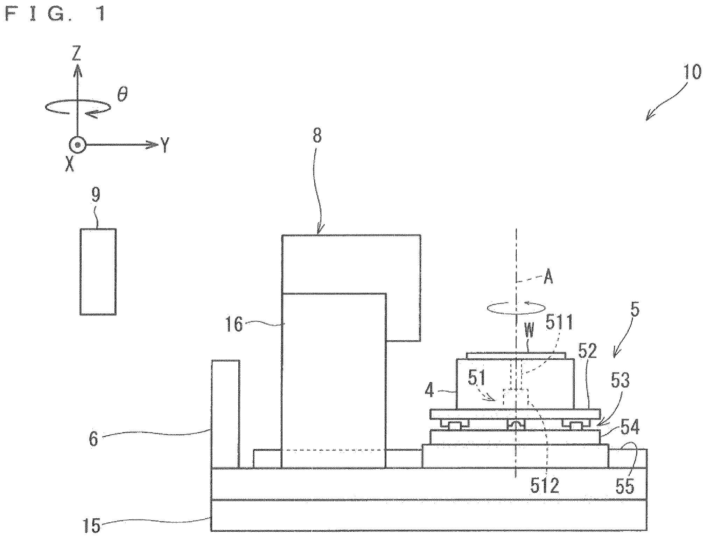

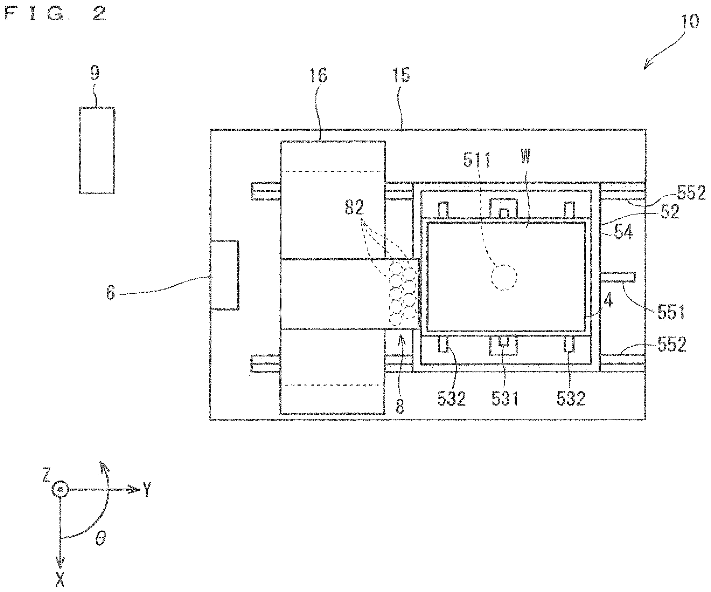

FIG. 1 is a side view illustrating a pattern exposure device 10 according to the preferred embodiment. FIG. 2 is a plan view illustrating the pattern exposure device 10 according to the preferred embodiment.

The pattern exposure device 10 is a direct drawing device configured to expose (draw) a pattern (for example, a circuit pattern) on an upper surface of a substrate W (photosensitive material), in which a layer of a photosensitive material such as a resist is formed, by irradiating the upper surface with patterned light (drawing light) provided with spatial modulation in accordance with CAD data. Examples of the substrate W processed at the pattern exposure device 10 include a semiconductor substrate, a printed circuit board, a color filter substrate included in a liquid crystal display device or the like, a flat panel display glass substrate included in a liquid crystal display device, a plasma display device, or the like, a magnetic disk substrate, an optical disk substrate, and a solar battery panel. In the following description, it is assumed that the substrate W is rectangular.

The pattern exposure device 10 includes a base 15 and a support frame 16. The support frame 16 is provided on the base 15 and formed in a transverse gate shape across the base 15 in an X-axis direction.

The pattern exposure device 10 includes a stage 4, a stage driving mechanism 5, a stage position measuring unit 6, an exposure unit 8, and a control unit 9.

### <Stage 4>

The stage 4 is a holding unit configured to hold the substrate W in a housing. The stage 4 is disposed on the base 15. Specifically, the stage 4 has, for example, a flat plate profile and places and holds the substrate W in a horizontal posture on an upper surface thereof. The upper surface of the stage 4 is provided with a plurality of suction holes (not illustrated). The stage 4 fixedly holds the substrate W on the upper surface of the stage 4 by providing negative pressure (suction pressure) through the suction holes.

### <Stage driving mechanism 5>

The stage driving mechanism 5 moves the stage 4 relative to the base 15. The stage driving mechanism 5 is disposed on the base 15.

The stage driving mechanism 5 includes a rotation mechanism 51 configured to rotate the stage 4 in a rotational direction (rotational direction about a Z axis (θ-axis direction)), a support plate 52 configured to support the stage 4 through the rotation mechanism 51, and an auxiliary scanning mechanism 53 configured to move the support plate 52 in an auxiliary scanning direction (the X-axis direction). The stage driving mechanism 5 further includes a base plate 54 configured to support the support plate 52 through the auxiliary scanning mechanism 53, and a main scanning mechanism 55 configured to move the base plate 54 in a main scanning direction (Y-axis direction).

The rotation mechanism 51 rotates the stage 4 about a rotational axis A perpendicular to the placement surface through the center of the upper surface of the stage 4 (placement surface of the substrate W). The rotation mechanism 51 may include, for example, a rotational axis unit 511 having an upper end fixed to a back-surface side of the placement surface and extending along a vertical axis, and a rotational drive unit (for example, a rotary motor) 512 provided at a lower end of the rotational axis unit 511 and configured to rotate the rotational axis unit 511. In this configuration, when the rotational drive unit 512 rotates the rotational axis unit 511, the stage 4 rotates about the rotational axis A in a horizontal plane.

The auxiliary scanning mechanism 53 includes a linear motor 531 including a mover attached to a lower surface of the support plate 52, and a stator laid on an upper surface of the base plate 54. In addition, a pair of guides 532 extending in the auxiliary scanning direction are laid on the base plate 54, and a ball bearing installed between each guide 532 and the support plate 52 is movable along the guide 532 while sliding on the guide 532. In other words, the support plate 52 is supported on the pair of guides 532 through the ball bearings. In this configuration, when the linear motor 531 is operated, the support plate 52 smoothly moves in the auxiliary scanning direction while being guided by the guides 532.

The main scanning mechanism 55 includes a linear motor 551 including a mover attached to a lower surface of the base plate 54, and a stator laid on the base 15. In addition, a pair of guides 552 extending in the main scanning direction are laid on the base 15, and for example, an air bearing is installed between each guide 552 and the base plate 54. The air bearing is constantly supplied with air from a utility facility, and the base plate 54 is supported on the guides 552 in a non-contact floating manner through the air bearing. In this configuration, when the linear motor 551 is operated, the base plate 54 smoothly moves without friction in the main scanning direction while being guided by the guides 552.

### <Stage position measuring unit 6>

The stage position measuring unit 6 measures the position of the stage 4. Specifically, the stage position measuring unit 6 is, for example, an interference laser length measuring device configured to emit laser light toward the stage 4 from out of the stage 4, receive reflected light of the laser light, and measure the position of the stage 4 (specifically, a Y position in the main scanning direction) based on interference between the reflected light and the emitted light.

### <Exposure unit 8>

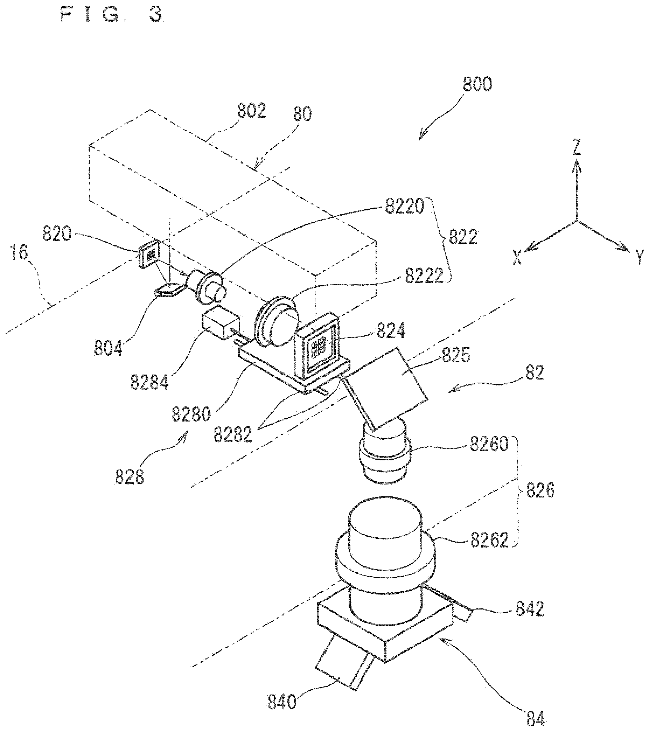

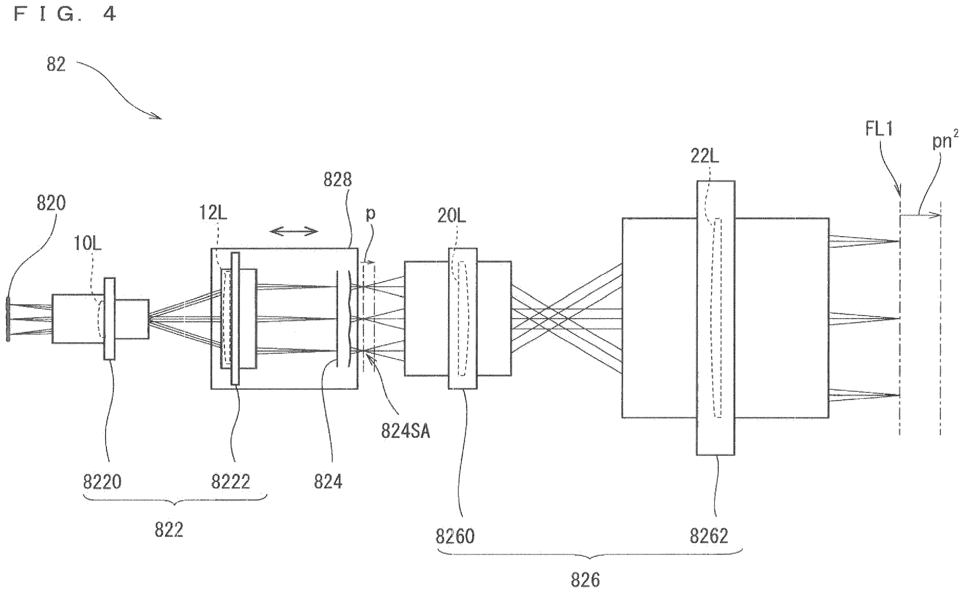

The exposure unit 8 is an optical device configured to form patterned light and irradiate the substrate W with the patterned light. The exposure unit 8 includes a plurality of exposure units 800. The configuration of the exposure units 800 will be described below with reference to FIGS. 3 and 4.

FIG. 3 is a schematic perspective view illustrating the configuration of the exposure units 800 according to the preferred embodiment. FIG. 4 is a schematic side view illustrating the configuration of an exposure head 82 according to the preferred embodiment. In FIG. 4, a mirror 825 is omitted, and a spatial light modulator 820, a first imaging optical system 822, a micro lens array 824, and a second imaging optical system 826 are arranged on an identical optical axis.

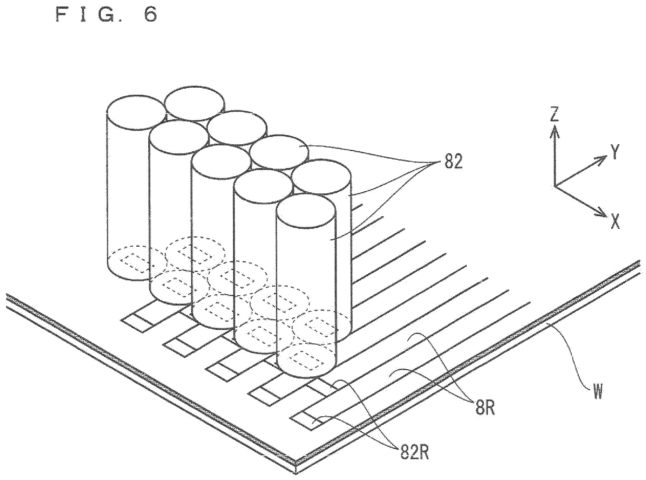

The exposure unit 8 includes a plurality (in this example, nine) of the exposure units 800, one of which is illustrated in FIG. 3. The number of the exposure units 800 thus mounted does not necessarily need to be nine but may be one. The exposure units 800 are respectively supported by the support frame 16. The support frame 16 supports the exposure heads 82 of the plurality of exposure units 800 arranged in a plurality of lines in the X-axis direction (refer to FIGS. 2 and 6).

### <Light source unit 80>

As illustrated in FIG. 3, a light source unit 80 includes a laser oscillator configured to receive a drive signal from a laser drive unit and output laser light. The light source unit 80 also includes an illumination optical system through which light (spot beam) output from the laser oscillator becomes light having uniform intensity distribution. The light output from the light source unit 80 is input to the exposure head 82. Laser light from one light source unit may be divided and input to the plurality of exposure heads 82.

### <Exposure head 82>

The exposure head 82 includes the spatial light modulator 820, the first imaging optical system 822, the micro lens array 824, the mirror 825, the second imaging optical system 826, a lens moving unit 828, and a measurement device 84. As illustrated in FIG. 3, the spatial light modulator 820, the first imaging optical system 822, the micro lens array 824, and the lens moving unit 828 are provided on the positive Z side of the support frame 16, whereas the second imaging optical system 826 and the measurement device 84 are provided on the positive Y side of the support frame 16.

The exposure head 82 is housed in a first house box (not illustrated) extending on the positive Z side and the positive Y side of the support frame 16. The light source unit 80 is housed in a second house box 802 fixed on the positive Z side of the first house box. Light output in the -Z direction by the light source unit 80 is reflected at a mirror 804 and incident on the spatial light modulator 820.

### <Spatial light modulator 820>

The spatial light modulator 820 includes a digital mirror device (DMD) configured to provide spatial modulation on the incident light and to reflect necessary light allowed to contribute to pattern drawing and unnecessary light not allowed to contribute to pattern drawing into directions different from each other. The DMD is, for example, a space modulation element including an array of 1920×1080 of micro mirrors (modulation elements) in a matrix on a memory cell. Each micro mirror serves as a pixel shaped in a square having sides of approximately 10 µm, and the entire DMD has a size of approximately 20 mm × 10 mm.

When a digital signal is written to the memory cell based on a control signal from the control unit 9, the micro mirror becomes tilted at a required angle about its diagonal line. Accordingly, patterned light in accordance with the digital signal is formed.

### <First imaging optical system 822>

The first imaging optical system 822 includes a first lens barrel 8220 holding a first lens 10L, and a second lens barrel 8222 holding a second lens 12L. The first lens 10L and the second lens 12L are disposed on the optical path of the patterned light formed by the spatial light modulator 820. The first lens 10L prepares, into parallel light, the patterned light output from the spatial light modulator 820 and guides the parallel light to the second lens 12L. The second lens 12L is telecentric on an image side and guides the patterned light from the first lens 10L to the micro lens array 824 in parallel to a lens optical axis.

In this example, the first imaging optical system 822 is an enlarging optical system configured to image the patterned light at a lateral magnification exceeding one (approximately two). The second lens 12L has a radius larger than that of the first lens 10L.

### <Micro lens array 824>

The micro lens array 824 includes the same number of micro lenses as the number of micro mirrors of the DMD. The micro lenses correspond to the respective micro mirrors of the DMD and are arrayed in a matrix. A light beam reflected at each micro mirror of the DMD is incident on the micro lens array 824 and condensed. The spot of this condensation is at each of spot arrays 824SA arranged in the pitch of the micro lenses of the micro lens array 824. The spot array 824SA has an image size of approximately 40 mm × 20 mm through magnification of approximately two at the first imaging optical system 822.

The light from each micro mirror of the DMD is condensed through the corresponding micro lens. Accordingly, the spot size of the light beam from the micro mirror is narrowed and maintained small, and thus the sharpness of an image (DMD image) projected on the substrate W is maintained at a high level.

The DMD of the spatial light modulator 820, the first lens 10L and the second lens 12L of the first imaging optical system 822, and the micro lens array 824 are disposed on an identical axis in the Y-axis direction. As illustrated in FIG. 3, the patterned light that has passed through the first imaging optical system 822 travels in the positive Y direction, and is incident on the mirror 825 and reflected into the -Z direction. The reflected patterned light is input to the second imaging optical system 826.

### <Second imaging optical system 826>

The second imaging optical system 826 includes a first lens barrel 8260 holding a first lens 20L, and a second lens barrel 8262 holding a second lens 22L. The first lens 20L and the second lens 22L is fixed to the support frame 16 with a required space therebetween in a Z-axis direction. More specifically, the first lens barrel 8260 and the second lens barrel 8262 are integrally coupled with each other through a coupling member to maintain a constant space between these lens barrels. The coupling member may house the first lens barrel 8260 and the second lens barrel 8262.

In this example, the second imaging optical system 826 is telecentric on image and object sides. Since the second imaging optical system 826 is telecentric on the image side, an image size of the patterned light is maintained constant when the position of the photosensitive material of the substrate W is shifted in the direction of the optical axis of the patterned light, which allows accurate exposure. In addition, since the second imaging optical system 826 is telecentric on the object side, the image size of the patterned light on the image side of the second imaging optical system can be maintained during exposure when the second lens 12L of the first imaging optical system 822 and the micro lens array 824 are moved in the direction of the optical axis as described later.

In this example, the second lens 22L of the second imaging optical system 826 is an enlarging optical system configured to achieve imaging in an enlarging manner at a lateral magnification exceeding one (approximately three). The second lens 22L has a radius larger than that of the first lens 20L. The spot array 824SA is projected onto a photosensitive material surface of the substrate W in a size of 120 mm × 60 mm through magnification of approximately three by the second imaging optical system 826.

The patterned light formed through the DMD of the spatial light modulator 820 is projected onto the substrate W through the first imaging optical system 822, the micro lens array 824, and the second imaging optical system 826. Along with movement of the stage 4 by the main scanning mechanism 55, the patterned light formed through the DMD is continuously changed by a reset pulse produced based on an encoder signal from the main scanning mechanism 55. In this manner, the patterned light is incident on the photosensitive material surface of the substrate W to form a striped image (refer to FIG. 6).

### <Lens moving unit 828>

The lens moving unit 828 includes a movable plate 8280, a pair of guide rails 8282, and a movement drive unit 8284.

The movable plate 8280 is a member formed in a rectangular plate shape and attached on the support frame 16. The second lens barrel 8222 and the micro lens array 824 are fixed on an upper surface of the movable plate 8280 with a required space therebetween in the Y-axis direction. The pair of guide rails 8282 are provided to the support frame 16. The movable plate 8280 extending in parallel to the guide rails 8282 in the Y-axis direction receives drive power from the movement drive unit 8284 and moves in the Y-axis direction while being guided by the pair of guide rails 8282. Accordingly, the second lens 12L and the micro lens array 824 are moved in a direction toward the first lens 10L (the negative Y direction) and in a direction away from the first lens 10L (the positive Y direction). The movement drive unit 8284 includes a linear-motor or ball-screw drive unit, and moves the movable plate 8280 upon reception of a control signal from the control unit 9.

### <Measurement device 84>

As illustrated in FIG. 3, the measurement device 84 is provided at a lower end part of the second lens barrel 8262. The measurement device 84 measures a separation distance between the exposure head 82 and the surface (photosensitive material surface) of the substrate W. The measurement device 84 includes an irradiator 840 configured to irradiate the substrate W with laser light and a photoreceiver 842 configured to receive laser light reflected at the substrate W. The irradiator 840 irradiates the upper surface of the substrate W with laser light in a spot shape along an axis tilted by a predetermined angle relative to a direction normal to the surface of the substrate W (in this example, the Z-axis direction). The photoreceiver 842 includes a line sensor extending in, for example, the Z-axis direction, and detects the incident position of the laser light on the line sensor. In this manner, the separation distance between the exposure head 82 and the photosensitive material surface of the substrate W is measured.

The separation distance detected by the measurement device 84 is sent to the control unit 9. A focus control unit 902 of the control unit 9 adjusts the imaging position (focus position) of patterned light output from the exposure head 82 in accordance with the separation distance. In other words, the focus control unit 902 outputs a control signal to the lens moving unit 828 to move the movable plate 8280, and accordingly move the second lens 12L of the second lens barrel 8222 and the micro lens array 824 in the Y-axis direction.

The measurement device 84 on the photosensitive material surface of the substrate W is positioned at a place adjacent to a place irradiated with patterned light output from the second imaging optical system 826. Thus, right before or substantially simultaneously with exposure, variation in the height of the photosensitive material surface of the substrate W is measured, and focusing of the patterned light is performed based on a result of the measurement.

It is not essential to provide the measurement device 84 to the second lens barrel 8262 of the second imaging optical system 826. For example, the measurement device 84 may be provided at a position separated from the second imaging optical system 826 or may be provided to the support frame 16. In this case, it is preferable that the height at each site on the photosensitive material surface of the substrate W may be measured before exposure to allow the focus control unit 902 to perform focusing at timing of exposure by the exposure head 82 at each site.

### <Control unit 9>

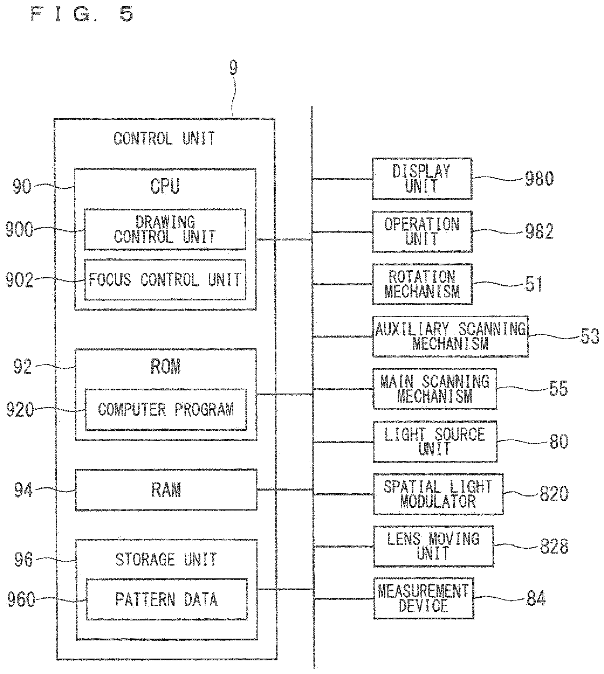

FIG. 5 is a block diagram illustrating bus wiring of the pattern exposure device 10 according to the preferred embodiment. The control unit 9 includes a CPU 90 configured to function as a calculation circuit, a read-only ROM 92, a RAM 94 used as a temporary working area for the CPU 90, and a storage unit 96 as a non-transitory recording medium.

The control unit 9 is connected, through bus wires, networks, or serial communication lines, with components of the pattern exposure device 10 such as the rotation mechanism 51, the auxiliary scanning mechanism 53, the main scanning mechanism 55, the light source unit 80 (specifically, a light source driver), the spatial light modulator 820, the lens moving unit 828, and the measurement device 84, and controls operation of each component.

The CPU 90 reads and executes a computer program 920 stored in the ROM 92 to perform calculation on various kinds of data stored in the RAM 94 or the storage unit 96. The control unit 9 has the configuration of a typical computer. A drawing control unit 900 and the focus control unit 902 are functions achieved through operation of the CPU 90 in accordance with the computer program 920. However, part or all of these elements may be achieved with, for example, a logic circuit. Contents of operation of these elements will be described later in detail.

The storage unit 96 stores pattern data 960 representing a pattern to be drawn on the substrate W. The pattern data 960 is, for example, image data obtained by converting data in a vector format produced by a CAD application or the like into data in a raster format. The control unit 9 controls the spatial light modulator 820 (the DMD) based on the pattern data 960 to modulate a light beam output from the exposure head 82. The pattern exposure device 10 generates a modulation reset pulse based on a linear scale signal sent from the linear motor 551 of the main scanning mechanism 55. Patterned light modulated in accordance with the position of the substrate W through the spatial light modulator 820 (the DMD) operating based on the reset pulse is output from each exposure head 82.

In the present preferred embodiment, the pattern data 960 may be a single image (image illustrating a pattern to be formed on the entire surface of the substrate W). However, for example, an image of a part to be drawn by each exposure head 82 may be generated individually for the exposure head 82 from the pattern data 960 representing the single image.

The control unit 9 is connected with a display unit 980 and an operation unit 982. The display unit 980 is a typical CRT monitor or liquid crystal display, and displays an image illustrating various kinds of data. The operation unit 982 includes various buttons and keys, a mouse, and a touch panel, and is operated by an operator to input various commands to the pattern exposure device 10. When the operation unit 982 includes a touch panel, the operation unit 982 may have part or all of the functionality of the display unit 980.

FIG. 6 is a schematic perspective view illustrating the exposure heads 82 performing pattern exposure. As illustrated in FIG. 6, the plurality of exposure heads 82 is arranged straight along a plurality of lines (in this example, two lines). The exposure heads 82 on the second line are respectively disposed between the two exposure heads 82 adjacent to each other on the first line. In other words, the plurality of exposure heads 82 is arranged in a staggered shape.

An exposure area 82R of each exposure head 82 is shaped in a rectangle including a short side in the main scanning direction (the Y-axis direction). Along with movement of the stage 4 in the Y-axis direction, a strip-shaped exposed region 8R is formed on the photosensitive material of the substrate W for each exposure head 82. The exposure heads 82 are arrayed in such a manner shifted from each other that the strip-shaped exposed regions 8R are arranged in the X-axis direction with no gap therebetween.

The configuration of the array of the plurality of exposure heads 82 is not limited to that illustrated in FIG. 6. For example, the exposure heads 82 may be arrayed to provide a gap natural-number times as large as a long side of the exposure area 82R between the exposed regions 8R adjacent to each other. In this case, main scanning in the Y-axis direction is performed a plurality of times at positions shifted from each other, in the X-axis direction, by the length of the long side of the exposure area 82R, thereby forming a plurality of the strip-shaped exposed regions 8R with no gap therebetween on the photosensitive material of the substrate W.

### <Focusing>

During the exposure process illustrated in FIG. 6, focusing is performed for each exposure head 82 in accordance with the position of the substrate W measured by the measurement device 84. Specifically, the lens moving unit 828 moves the movable plate 8280 so that a focus position FL1 of patterned light output from the exposure head 82 coincides with the position of the photosensitive material surface of the substrate W in the Z-axis direction.

For example, it is assumed that the lens moving unit 828 moves the movable plate 8280 by p in the positive Y direction. In this case, the second lens 12L of the first imaging optical system 822 and the micro lens array 824 are moved by p in the positive Y direction, and accordingly the spot array 824SA is moved by p in the positive Y direction (refer to FIG. 4). When n represents the lateral magnification of the second imaging optical system 826, a longitudinal magnification thereof is the square (n²) of the lateral magnification. Thus, the focus position FL1 of the second imaging optical system 826 is moved by pn² in the -Z direction.

Specifically, when a distance between the focus position of the patterned light and the photosensitive material surface of the substrate W are shifted from each other by 100 µm, an object plane of the second imaging optical system needs to be moved by approximately 11 µm (= 100/9) because the second imaging optical system 826 has a longitudinal magnification of nine for a lateral magnification of three. The object plane corresponds to the plane of the spot array 824SA of the micro lens array 824, and thus the plane of the spot array 824SA needs to be moved in the direction of focusing. Accordingly, the lens moving unit 828 needs to move the second lens barrel 8222 of the first imaging optical system 822 and the micro lens array 824 by approximately 11 µm in the direction of focusing.

When the second lens barrel 8222 and the micro lens array 824 are integrally moved, the focus position of a DMD image projected onto the micro lens array 824 by the first imaging optical system 822 can be maintained at the surface of the micro lens array 824. Accordingly, the spot array 824SA can be moved in the direction of focusing while the state of condensation of each spot of the spot array 824SA is maintained.

Here, the focus position FL1 can be changed also by moving the second lens 22L of the second imaging optical system 826. In this case, however, the second lens 22L of the second imaging optical system 826 needs to be moved by 100 µm for focusing. On the other hand, the second lens 12L of the first imaging optical system 822 and the micro lens array 824 only need to be moved by an amount obtained by dividing a defocusing amount by the longitudinal magnification of the second imaging optical system 826. This leads to reduction in the size of the lens moving unit 828 and to fast execution of focusing.

When the lateral magnification of the second imaging optical system 826 is two to three, the second lens 12L of the first imaging optical system 822 have diameters 1/2 to 1/3 times large as that of the second lens 22L of the second imaging optical system 826. The second lens 12L has a weight can be approximately 1/4 to 1/9 times heavy as that of the second lens 22L. Thus, the size of the exposure head 82 can be reduced when the scheme of moving the second lens barrel 8222 through the lens moving unit 828 is employed instead of the scheme of moving the second lens barrel 8262, which requires a large movement mechanism. This configuration facilitates holding of the exposure heads 82 being arranged.

The first imaging optical system 822 desirably has a magnification as small as possible. Then, the sizes of the second lens 12L and the micro lens array 824 can be reduced. This leads to reduction in the total weight of the second lens 12L and the micro lens array 824, and thus reduction in the size of the lens moving unit 828. Accordingly, the size of the exposure head 82 can be reduced, which facilitates supporting of the exposure heads 82 being arranged. In addition, the reduction of the total weight of the second lens 12L and the micro lens array 824 facilitates accurate movement of the movable plate 8280.

The second imaging optical system 826 desirably has a magnification larger than the magnification of the first imaging optical system 822, and as large as possible. This configuration can achieve improved throughput of exposure.

### <2. Modification>

Although the preferred embodiment is described above, the present invention is not limited to the above description, but may be provided with various modifications.

In the above-described preferred embodiment, the first imaging optical system 822 and the second imaging optical system 826 are both enlarging optical systems. However, such configuration is not essential. For example, only one of the first imaging optical system 822 and the second imaging optical system 826 may be an enlarging optical system.

In the above-described preferred embodiment, the spatial light modulator 820 is provided with the DMD. However, such configuration is not essential. For example, a grating light valve (GLV) may be employed in place of the DMD. The GLV includes a micro ribbon array of micro ribbons, which are optical diffraction elements, arrayed in line. Grayscaled strip-shaped patterned light can be formed by controlling the height of each micro ribbon while the micro ribbon array is irradiated with light. The present invention is still effective when such a GLV is employed.

While the present invention is described above in detail, but the foregoing description is in all aspects illustrative and not restrictive. It is therefore understood that numerous modifications and variations can be devised without departing from the scope of the present invention.

## Claims

1. A pattern exposure device (10) comprising:
a holding unit (4) configured to hold a photosensitive material;
an exposure head (82) configured to output patterned light toward said photosensitive material;
a measurement unit (84) configured to measure the position of said photosensitive material held by said holding unit (4); and
a focus control unit (902) configured to adjust an imaging position of said patterned light in accordance with the position of said photosensitive material,
wherein said exposure head (82) includes:
a spatial light modulator (820) including a plurality of modulation elements configured to form patterned light by performing spatial light modulation on light output from a light source (80);
a first imaging optical system (822) including a first lens (10L) and a second lens (12L) disposed on an optical path of patterned light output from said spatial light modulator (820), said second lens (12L) being telecentric on an image side;
a micro lens array (824) including a plurality of micro lenses configured to condense said patterned light that has passed through said second lens (12L) of said first imaging optical system (822);
a second imaging optical system (826) disposed on an optical path of said patterned light that has passed through said micro lens array (824) and configured to image said patterned light; **characterized by**
a lens moving unit configured to integrally move said second lens (12L) and said micro lens array (824) in directions toward and away from said first lens (10L);
wherein said focus control unit (902) is configured to adjust said imaging position of said patterned light by controlling operation of said lens moving unit.

2. The pattern exposure device (10) according to claim 1, wherein said second imaging optical system (826) is telecentric on image and object sides.

3. The pattern exposure device (10) according to claim 1 or 2, wherein said first imaging optical system (822) is an enlarging optical system configured to achieve imaging at a lateral magnification exceeding one time.

4. The pattern exposure device (10) according to claim 3, further comprising an exposure-head supporting unit (16) configured to support a plurality of said exposure heads (82) arranged side by side.

5. The pattern exposure device (10) according to any one of claims 1 to 4, wherein said second imaging optical system (826) is an enlarging optical system configured to achieve imaging at a lateral magnification larger than a lateral magnification of said first imaging optical system (822).

6. An exposure head (82) configured to output patterned light, comprising:
a spatial light modulator (820) including a plurality of modulation elements configured to form patterned light by performing spatial light modulation on light output from a light source (80);
a first imaging optical system (822) including a first lens (10L) and a second lens (12L) disposed on an optical path of patterned light output from said spatial light modulator (820), said second lens (12L) being telecentric on an image side;
a micro lens array (824) including a plurality of micro lenses configured to condense said patterned light that has passed through said second lens (12L) of said first imaging optical system (822);
a second imaging optical system (826) disposed on an optical path of said patterned light that has passed through said micro lens array (824) and configured to image said patterned light, said second imaging optical system (826) being telecentric on image and object sides; **characterized by**
a lens moving unit configured to integrally move said second lens (12L) and said micro lens array (824) in directions toward and away from said first lens (10L).

7. A pattern exposure method comprising:
a process (a) of holding a photosensitive material;
a process (b) of outputting patterned light toward said photosensitive material;
a process (c) of measuring the position of said photosensitive material; and
a process (d) of adjusting an imaging position of said patterned light in said process (b) in accordance with the position of said photosensitive material measured in said process (c),
wherein said process (b) includes:
a process (b-1) of forming said patterned light by providing spatial modulation, through a plurality of modulation elements, on light output from a light source (80);
a process (b-2) of imaging said patterned light through a first imaging optical system (822) including a first lens (10L) and a second lens (12L) disposed on an optical path of said patterned light, said second lens (12L) being telecentric on an image side;
a process (b-3) of condensing, through a micro lens array (824) including a plurality of micro lenses, said patterned light output from said second lens (12L) of said first imaging optical system (822) in said process (b-1); and
a process (b-4) of imaging, through a second imaging optical system (826), said patterned light that has passed through said micro lens array (824) in said process (b-3), **characterized in that**
said process (d) includes a process (d-1) of integrally moving said second lens (12L) and said micro lens array (824) in directions toward and away from said first lens (10L).

## Patentansprüche

1. Musterbelichtungsvorrichtung (10), umfassend:
eine Halteeinheit (4), die dazu eingerichtet ist, ein lichtempfindliches Material zu halten;
einen Belichtungskopf (82), der dazu eingerichtet ist, gemustertes Licht auf das lichtempfindliche Material auszugeben;
eine Messeinheit (84), die dazu eingerichtet ist, die Position des von der Halteeinheit (4) gehaltenen lichtempfindlichen Materials zu messen; und
eine Fokussteuereinheit (902), die dazu eingerichtet ist, eine Abbildungsposition des gemusterten Lichts in Übereinstimmung mit der Position des lichtempfindlichen Materials einzustellen,
wobei der Belichtungskopf (82) umfasst:
einen räumlichen Lichtmodulator (820), der eine Vielzahl von Modulationselementen enthält, die dazu eingerichtet sind, gemustertes Licht zu bilden, indem sie eine räumliche Lichtmodulation an dem von einer Lichtquelle (80) ausgegebenen Licht durchführen;
ein erstes optisches Abbildungssystem (822), das eine erste Linse (10L) und eine zweite Linse (12L) enthält, die auf einem optischen Pfad von gemustertem Licht, das von dem räumlichen Lichtmodulator (820) ausgegeben wird, angeordnet sind, wobei die zweite Linse (12L) auf einer Bildseite telezentrisch ist;
eine Mikrolinsenanordnung (824) mit einer Vielzahl von Mikrolinsen, die dazu eingerichtet sind, das durch die zweite Linse (12L) des ersten optischen Abbildungssystems (822) hindurchgegangene gemusterte Licht zu bündeln;
ein zweites optisches Abbildungssystem (826), das auf einem optischen Pfad des gemusterten Lichts angeordnet ist, das die Mikrolinsenanordnung (824) durchlaufen hat, und das dazu eingerichtet ist, das gemusterte Licht abzubilden; **gekennzeichnet durch**
eine Linsenbewegungseinheit, die dazu eingerichtet ist, die zweite Linse (12L) und die Mikrolinsenanordnung (824) integral in Richtungen zu der ersten Linse (10L) hin und von ihr weg zu bewegen;
wobei die Fokussteuereinheit (902) dazu eingerichtet ist, die Abbildungsposition des gemusterten Lichts durch Steuern des Betriebs der Linsenbewegungseinheit einzustellen.

2. Musterbelichtungsvorrichtung (10) nach Anspruch 1, wobei das zweite optische Abbildungssystem (826) auf der Bild- und Objektseite telezentrisch ist.

3. Musterbelichtungsvorrichtung (10) nach Anspruch 1 oder 2, wobei das erste optische Abbildungssystem (822) ein optisches Vergrößerungssystem ist, das dazu eingerichtet ist, eine Abbildung mit einer seitlichen Vergrößerung von mehr als einem Mal zu erreichen.

4. Musterbelichtungsvorrichtung (10) nach Anspruch 3, die ferner eine Belichtungskopf-Halteeinheit (16) umfasst, die dazu eingerichtet ist, eine Vielzahl der nebeneinander angeordneten Belichtungsköpfe (82) zu halten.

5. Musterbelichtungsvorrichtung (10) nach einem der Ansprüche 1 bis 4, wobei das zweite optische Abbildungssystem (826) ein optisches Vergrößerungssystem ist, das dazu eingerichtet ist, eine Abbildung mit einer seitlichen Vergrößerung zu erreichen, die größer als eine seitliche Vergrößerung des ersten optischen Abbildungssystems (822) ist.

6. Belichtungskopf (82), der dazu eingerichtet ist, gemustertes Licht auszugeben, umfassend:
einen räumlichen Lichtmodulator (820), der eine Vielzahl von Modulationselementen enthält, die dazu eingerichtet sind, gemustertes Licht zu bilden, indem sie eine räumliche Lichtmodulation an dem von einer Lichtquelle (80) ausgegebenen Licht durchführen;
ein erstes optisches Abbildungssystem (822), das eine erste Linse (10L) und eine zweite Linse (12L) enthält, die auf einem optischen Pfad von gemustertem Licht, das von dem räumlichen Lichtmodulator (820) ausgegeben wird, angeordnet sind, wobei die zweite Linse (12L) auf einer Bildseite telezentrisch ist;
eine Mikrolinsenanordnung (824) mit einer Vielzahl von Mikrolinsen, die dazu eingerichtet sind, das durch die zweite Linse (12L) des ersten optischen Abbildungssystems (822) hindurchgegangene gemusterte Licht zu bündeln;
ein zweites optisches Abbildungssystem (826), das auf einem optischen Pfad des gemusterten Lichts angeordnet ist, das die Mikrolinsenanordnung (824) durchlaufen hat, und das dazu eingerichtet ist, das gemusterte Licht abzubilden, wobei das zweite optische Abbildungssystem (826) auf Bild- und Objektseiten telezentrisch ist; **dadurch gekennzeichnet, dass**
eine Linsenbewegungseinheit, die dazu eingerichtet ist, die zweite Linse (12L) und die Mikrolinsenanordnung (824) integral in Richtungen zu der ersten Linse (10L) hin und von ihr weg zu bewegen;

7. Verfahren zur Musterbelichtung, umfassend:
ein Verfahren (a) zum Halten eines lichtempfindlichen Materials;
ein Verfahren (b) zur Ausgabe von gemustertem Licht auf das lichtempfindliche Material;
ein Verfahren (c) zum Messen der Position des lichtempfindlichen Materials; und
ein Verfahren (d) zum Einstellen einer Abbildungsposition des gemusterten Lichts in dem Verfahren (b) in Übereinstimmung mit der in dem Verfahren (c) gemessenen Position des lichtempfindlichen Materials,
wobei das Verfahren (b) umfasst:
ein Verfahren (b-1) zum Bilden des gemusterten Lichts durch Vorsehen einer räumlichen Modulation durch eine Vielzahl von Modulationselementen auf der Lichtausgabe von einer Lichtquelle (80);
ein Verfahren (b-2) zum Abbilden des gemusterten Lichts durch ein erstes optisches Abbildungssystem (822) mit einer ersten Linse (10L) und einer zweiten Linse (12L), die auf einem optischen Pfad des gemusterten Lichts angeordnet sind, wobei die zweite Linse (12L) auf einer Bildseite telezentrisch ist;
ein Verfahren (b-3) zum Kondensieren des gemusterten Lichts, das von der zweiten Linse (12L) des ersten optischen Abbildungssystems (822) in dem Verfahren (b-1) ausgegeben wird, durch eine Mikrolinsenanordnung (824), die eine Vielzahl von Mikrolinsen enthält; und
ein Verfahren (b-4) zum Abbilden des gemusterten Lichts, das die Mikrolinsenanordnung (824) in dem Verfahren (b-3) durchlaufen hat, durch ein zweites optisches Abbildungssystem (826), **dadurch gekennzeichnet, dass**
das Verfahren (d) einen Prozess (d-1) des integralen Bewegens der zweiten Linse (12L) und der Mikrolinsenanordnung (824) in Richtungen auf die erste Linse (10L) zu und von ihr weg umfasst.

## Revendications

1. Dispositif d'exposition de motifs (10) comprenant :
une unité de maintien (4) configurée pour maintenir un matériau photosensible ;
une tête d'exposition (82) configurée pour émettre une lumière à motif vers ledit matériau photosensible ;
une unité de mesure (84) configurée pour mesurer la position dudit matériau photosensible maintenu par ladite unité de maintien (4) ; et
une unité de commande de mise au point (902) configurée pour régler une position d'imagerie de ladite lumière à motif suivant la position dudit matériau photosensible,
dans lequel ladite tête d'exposition (82) comporte :
un modulateur spatial de lumière (820) comportant une pluralité d'éléments de modulation configurés pour former une lumière à motif en réalisant une modulation spatiale de lumière sur une lumière émise par une source lumineuse (80) ;
un premier système optique d'imagerie (822) comportant une première lentille (10L) et une deuxième lentille (12L) disposées sur un chemin optique d'une lumière à motif émise par ledit modulateur spatial de lumière (820), ladite deuxième lentille (12L) étant télécentrique du côté image ;
un réseau de microlentilles (824) comportant une pluralité de microlentilles configurées pour condenser ladite lumière à motif qui a traversé ladite deuxième lentille (12L) dudit premier système optique d'imagerie (822) ;
un deuxième système optique d'imagerie (826) disposé sur un chemin optique de ladite lumière à motif qui a traversé ledit réseau de microlentilles (824) et configuré pour imager ladite lumière à motif ; **caractérisé par**
une unité de déplacement de lentilles configurée pour déplacer ladite deuxième lentille (12L) et ledit réseau de microlentilles (824) en un seul tenant dans des directions proches et éloignées de ladite première lentille (10L) ;
dans lequel ladite unité de commande de mise au point (902) est configurée pour régler ladite position d'imagerie de ladite lumière à motif en commandant le fonctionnement de ladite unité de déplacement de lentilles.

2. Dispositif d'exposition de motifs (10) selon la revendication 1, dans lequel ledit deuxième système optique d'imagerie (826) est télécentrique du côté image et du côté objet.

3. Dispositif d'exposition de motifs (10) selon la revendication 1 ou 2, dans lequel ledit premier système optique d'imagerie (822) est un système optique d'agrandissement configuré pour réaliser l'imagerie à un grossissement latéral dépassant un certain temps.

4. Dispositif d'exposition de motifs (10) selon la revendication 3, comprenant en outre une unité de support de tête d'exposition (16) configurée pour supporter une pluralité desdites têtes d'exposition (82) agencées côte à côte.

5. Dispositif d'exposition de motifs (10) selon l'une des revendications 1 à 4, dans lequel ledit deuxième système optique d'imagerie (826) est un système optique d'agrandissement configuré pour réaliser l'imagerie à un grossissement latéral supérieur à un grossissement latéral dudit premier système optique d'imagerie (822).

6. Tête d'exposition (82) configurée pour émettre une lumière à motif, comprenant :
un modulateur spatial de lumière (820) comportant une pluralité d'éléments de modulation configurés pour former une lumière à motif en réalisant une modulation spatiale de lumière sur une lumière émise par une source lumineuse (80) ;
un premier système optique d'imagerie (822) comportant une première lentille (10L) et une deuxième lentille (12L) disposées sur un chemin optique d'une lumière à motif émise par ledit modulateur spatial de lumière (820), ladite deuxième lentille (12L) étant télécentrique du côté image ;
un réseau de microlentilles (824) comportant une pluralité de microlentilles configurées pour condenser ladite lumière à motif qui a traversé ladite deuxième lentille (12L) dudit premier système optique d'imagerie (822) ;
un deuxième système optique d'imagerie (826) disposé sur un chemin optique de ladite lumière à motif qui a traversé ledit réseau de microlentilles (824) et configuré pour imager ladite lumière à motif, ledit deuxième système optique d'imagerie (826) étant télécentrique du côté image et du côté objet ; **caractérisé par**
une unité de déplacement de lentilles configurée pour déplacer ladite deuxième lentille (12L) et ledit réseau de microlentilles (824) en un seul tenant dans des directions proches et éloignées de ladite première lentille (10L).

7. Procédé d'exposition de motifs comprenant :
un processus (a) de maintien d'un matériau photosensible ;
un processus (b) d'émission d'une lumière à motif vers ledit matériau photosensible ;
un processus (c) de mesure de la position dudit matériau photosensible ; et
un processus (d) de réglage d'une position d'imagerie de ladite lumière à motif au cours dudit processus (b) suivant la position dudit matériau photosensible mesurée au cours dudit processus (c),
dans lequel ledit processus (b) comporte :
un processus (b-1) de formation de ladite lumière à motif en fournissant une modulation spatiale, à travers une pluralité d'éléments de modulation, sur une lumière émise par une source lumineuse (80) ;
un processus (b-2) d'imagerie de ladite lumière à motif à travers un premier système optique d'imagerie (822) comportant une première lentille (10L) et une deuxième lentille (12L) disposées sur un chemin optique de ladite lumière à motif, ladite deuxième lentille (12L) étant télécentrique du côté image ;
un processus (b-3) de condensation, à travers un réseau de microlentilles (824) comportant une pluralité de microlentilles, de ladite lumière à motif émise par ladite deuxième lentille (12L) dudit premier système optique d'imagerie (822) au cours dudit processus (b-1) ; et
un processus (b-4) d'imagerie, à travers un deuxième système optique d'imagerie (826), de ladite lumière à motif qui a traversé ledit réseau de microlentilles (824) au cours dudit processus (b-3), **caractérisé en ce que**
ledit processus (d) comporte un processus (d-1) de déplacement de ladite deuxième lentille (12L) et dudit réseau de microlentilles (824) en un seul tenant dans des directions proches et éloignées de ladite première lentille (10L).
